# EUROPEAN PATENT APPLICATION

(11) **EP 0 991 120 A2**
(43) Date of publication of application: **05.04.2000**
(21) Application number: 99307520.9
(22) Date of filing: 23.09.1999
(51) Int. Cl.: H01L 23/36

(54) **Semiconductor unit**

(30) Priority: 30.09.1998 JP 27760898
(71) Applicant: SHIN-ETSU CHEMICAL CO., LTD., Chiyoda-ku Tokyo (JP)
(72) Inventor: Yamada, kunihiro, Cilicone Elec. Mat. Res. Center, Matsuidacho, Usui-Gun, Gunma-Ken (JP); Isobe, Kenichi, Cilicone Elec. Mat. Res. Center, Matsuidacho, Usui-Gun, Gunma-Ken (JP); Takahashi, Takayuki, Silicone Elec. Mat. Res. Ctr., Matsuidacho, Usui-Gun, Gunma-Ken (JP)
(74) Representative: Bubb, Antony John Allen

(57) **Abstract**

A semiconductor unit comprising an IC package fitted on a printed wiring substrate and a heat dissipater provided on the IC package surface, with the unit further comprising a thermally conductive material that has a thermal conductivity of at least 2.5 W/mK and is laid in a thickness of from 50 to 500 µm between the IC package surface and the heat dissipater.

## Description

The present invention relates to a semiconductor unit, such as a central processing unit (CPU), packaged on a printed wiring substrate.

IC packages as electronic parts packaged on a printed wiring substrate, including CPU, generate heat during the operation to raise the temperature, and thereby they have a considerable drop in their performance or cause breakdown. Therefore, it is necessary to cool the IC packages. Hitherto, the dissipation of the heat generating from the exothermic bodies of IC packages has been carried out by natural convection or the forced convection using a fan installed in the unit.

However, those ways of heat dissipation are inadequate for the calorific value that has been increasing with the progress in IC package functions. As a result, the IC package is overheated to face the problem of a performance drop or damage. For the purpose of improving the efficiency of heat dissipation, the method of welding a heat dissipater onto the surface of IC package under pressure has been proposed and put to practical use. However, gaps are formed between the pressure-welded surfaces of an IC package and a heat dissipater so long as the heat dissipater is pressure-welded simply onto the IC package surface, so that the heat dissipation efficiency cannot be achieved as it was designed.

Such a defect can be reformed by laying a thermally conductive material, such as a thermally conductive sheet or thermally conductive grease, between the IC package and heat dissipater surfaces to be pressure-welded. The reformation depends greatly on the properties of the thermally conductive material laid between those elements. Therefore, considerable efforts have so far been exerted to improve the properties of thermally conductive materials. Although those efforts have been instrumental to achieve extensive improvement in the heat dissipation efficiency, they have revealed that the subject to be attacked next consists in the yield problem arising from the uneven quality of those semiconductor units as manufactured products.

As a result of our intensive studies to improve the consistency of the product quality of manufactured semiconductor units as well as to further enhance the efficiency in dissipating the generated heat from IC packages, it has been found that the yield of semiconductor units as manufactured products can be improved by laying a thermally conductive material having a thermal conductivity of at least 2.5 W/mK in a thickness of from 50 to 500 µm between an IC package and a heat dissipater, thereby achieving the invention.

Therefore, an object of the present invention is to provide a semiconductor unit having high heat dissipation efficiency and excellent manufacturing suitability.

The aforementioned object of the invention is attained with a semiconductor unit comprising an IC package fitted on a printed wiring substrate and a heat dissipater provided on the IC package surface, with the unit further comprising a thermally conductive material that has a thermal conductivity of at least 2.5 W/mK and is laid in a thickness of from 50 to 500 pm between the IC package surface and the heat dissipater.

In accordance with the invention, the thermally conductive material having a thermal conductivity of at least 2.5 W/mK can be laid between an IC package and a heat dissipater in a state that no gaps are left between those elements; as a result, it can ensure the consistent removal of the heat from the IC package to improve the reliability of the electronic parts as a whole. Therefore, the present semiconductor unit can ensure a high yield for the manufactured products, and has an excellent manufacturing suitability.

### BRIEF DESCRIPTION OF DRAWING

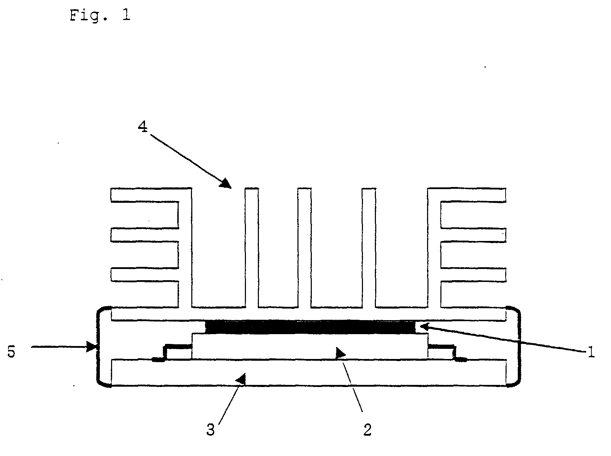

Fig. 1 is a longitudinal section of one example of a semiconductor unit according to the present invention. Therein, the figure 1 denotes a heat-reducing silicone grease composition, the figure 2 denotes an IC package, such as a central processing unit (CPU), the figure 3 denotes a printed wiring substrate, the figure 4 denotes a heat dissipater, and the figure 5 denotes a clamp.

### DETAILED DESCRIPTION OF THE INVENTION

In one embodiment as shown in Fig. 1, the present semiconductor unit is equipped with an IC package fitted on a printed wiring substrate and a heat dissipater to be pressure-welded onto the IC package surface, and further provided with a thermally conductive material having a thermal conductivity of at least 2.5 W/mK in a state that the material is sandwiched in a thickness of 50-500 µm between the IC package and the heat dissipater.

The thermally conductive material used in the invention has no particular limitation, provided that it has a thermal conductivity of at least 2.5 W/mK. However, it is especially favorable that the thermal conductivity thereof be at least 2.7 W/mK. When the thermal conductivity is lower than 2.5 W/mK, sufficient heat dissipating effect cannot be achieved. Additionally, the measurement of thermal conductivity in the invention is carried out using a hot-wire thermal conductivity meter, Model QTM-500 (trade name, made by KYOTO ELECTRONICS MFG. CO., LTD.).

The thermally conductive material may have the form of sheet or grease. However, the form of grease is preferred from the viewpoint of leaving no gaps between an IC package and a heat dissipater. In particular, the thermally conductive silicone grease for heat reduction use is advantageous to the invention.

The thermally conductive material is fixed and pressed between an IC package and a heat dissipater by fastening the heat dissipater and a printed wiring substrate together with clamps. Therein, the thermally conductive material inserted between the IC package and the heat dissipater is required to have a thickness of 50 to 500 µm. In particular, it is desirable to control the thickness to the range of 100 to 200 µm from the viewpoint of improving the performance of a semiconductor unit and the production yield thereof. Additionally, the thickness determination in the invention is carried out according to JIS B 7524 (see Annex 1 to the description). When the thermally conductive material has a less thickness than 50 µm, a slight aberration in the applied pressure is likely to give rise to gaps between the IC package and the heat dissipater; while, when it has a greater thickness than 500 µm, the heat resistance thereof is increased to result in diminishing its heat-reducing effect.

In assembling the present semiconduct unit, a sheet of thermally conductive material is pasted to the surface of an IC package, or a commercially available syringe is filled with a heat-reducing grease composition and therefrom the grease composition is dispensed to the surface of an IC package. In view of the working efficiency, therefore, it is desirable for the grease composition used to have a viscosity of from 1,000 to 10,000 kgm⁻¹s^{-s} (1,000 to 10,000 poise), preferably from 2,000 to 4,000 kgm⁻¹s⁻¹ (2,000 to 4,000 poise). When the grease composition hasa viscosity lower than 1,000 kgm⁻¹s⁻¹ (1,000 poise), it causes sagging stain upon dispensation; while, when the viscosity thereof is higher than 10,000 kgm⁻¹s⁻¹ (10,000 poise), the dispensation efficiency is lowered. Additionally, the aforementioned viscosity values are those measured at 25°C with a spiral-pump viscometer.

The heat-reducing grease composition used in the invention can be prepared, e.g., by mixing and kneading a mineral powder having a good thermal conductivity, such as an aluminum nitride powder, a boron nitride powder, a zinc oxide powder, an alumina powder or a mixture of two or more thereof, with a known base oil. As the base oil, organopolysiloxanes are preferred over the other base oils.

Now, the present invention will be illustrated in greater detail with CPU taken as one example of an IC package. However, the invention should not be construed as being limited to the following example.

The entire disclosure of corresponding Japanese application No. Hei 10-277608, filed on September 30, 1998, is hereby incorporated by reference.

### EXAMPLE

Fig. 1 is a longitudinal section of an example of the present semiconductor unit. As shown in Fig. 1, the present unit is constituted of CPU 2 packaged on a printed wiring substrate 3, a heat dissipater 4 and a thermally conductive material 1 inserted between the CPU 2 and the heat dissipater 4. Therein, the heat dissipater 4 is made of aluminum and has a fins-attached structure with the intention of extending the surface area to improve the heat-reducing function. The heat dissipater 4 and the printed wiring substrate 3 are fastened and fixed by means of clamps 5, and thereby the pressure is applied to the thermally conductive material.

The thermally conductive material used therein was a heat-reducing silicone grease composition prepared by compounding the following components (1) to (3), subjecting them to 30 minutes preliminary mixing with a planetary mixer (made by Inoue Seisakusho Co., Ltd.), and then kneading 3 times with a three-roll mill.
(1) Aluminum nitride powder having an average grain size of 0.5 to 10 µm and a specific surface area of 1 to 10 m²/g: 70 % by weight,
(2) Organopolysiloxane represented by the following formula and having a viscosity of 390 cs at 25°C: 10 % by weight, 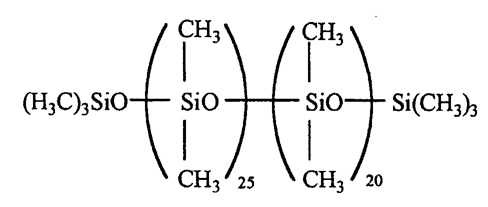
(3) Zinc oxide powder having an average grain size of 0.2 to 5 µm: 20 % by weight.

The thus prepared heat-reducing silicone grease composition had the thermal conductivity of 2.8 W/mK (measured with QTM-500, trade name made by KYOTO ELECTRONICS MFG. CO. LTD.) and the viscosity of 2,500 poise measured at 25°C with a viscometer, Model PC-ITL (trade name, made by Malcom Co., Ltd.). In the semiconductor unit as an example of the invention, 0.2 g of the heat-reducing grease composition was inserted between an IC package surface measuring 2 cm x 2 cm in size and the heat dissipater. Therein, the thickness of the grease composition was 180 µm.

The IC package applied to the present semiconductor unit having the aforementioned structure was CPU generally used in host computers, personal computers and word processors, the exothermic quality of which was on such a level as to raise its temperature up to 170°C during the operation. As a result of performance test, neither performance drop nor break of CPU arising from heat accumulation was detected, which proved that the present semiconductor unit enabled constant heat diffusion and heat dissipation.

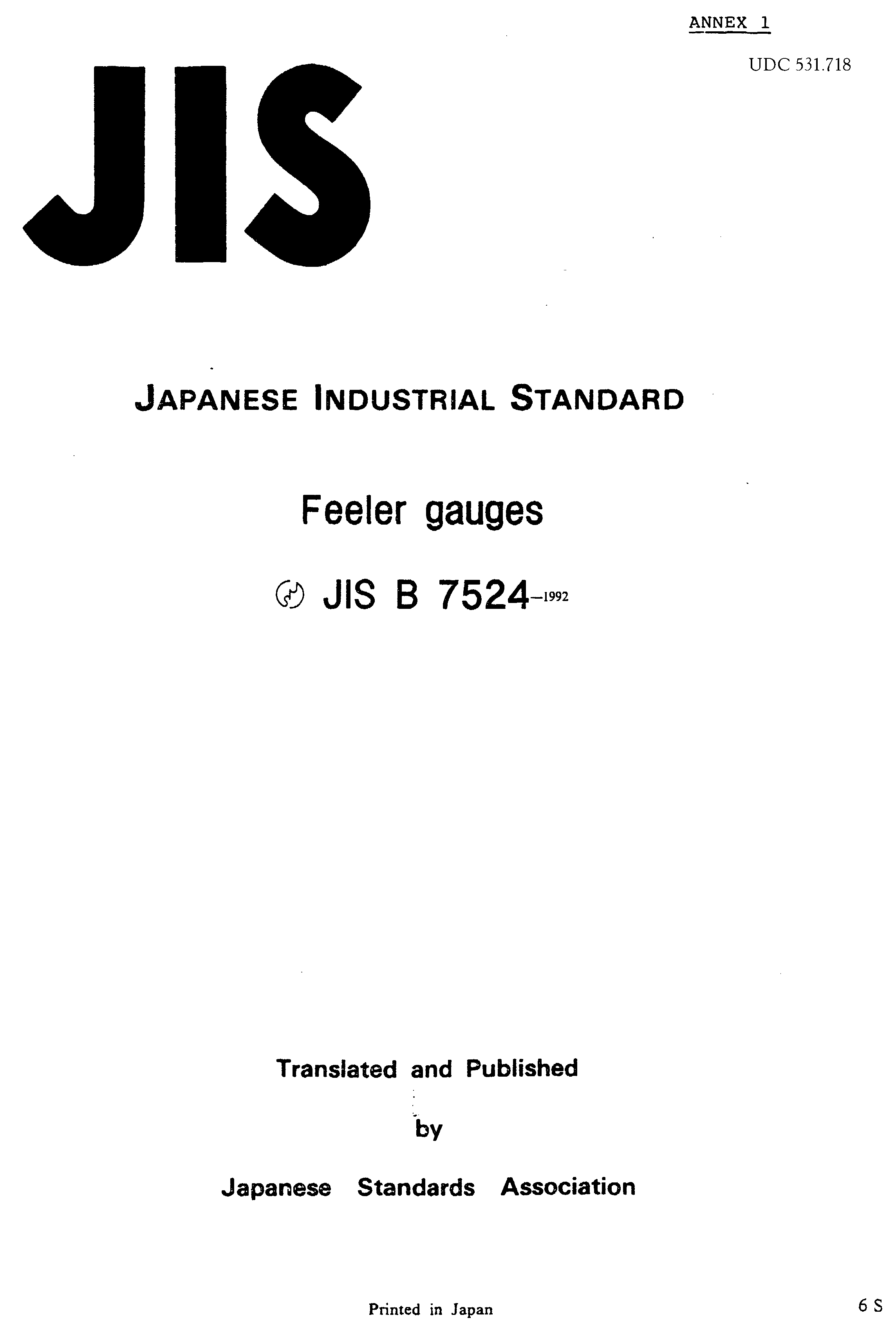

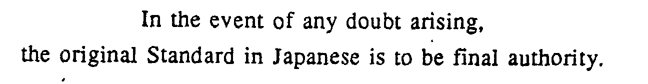

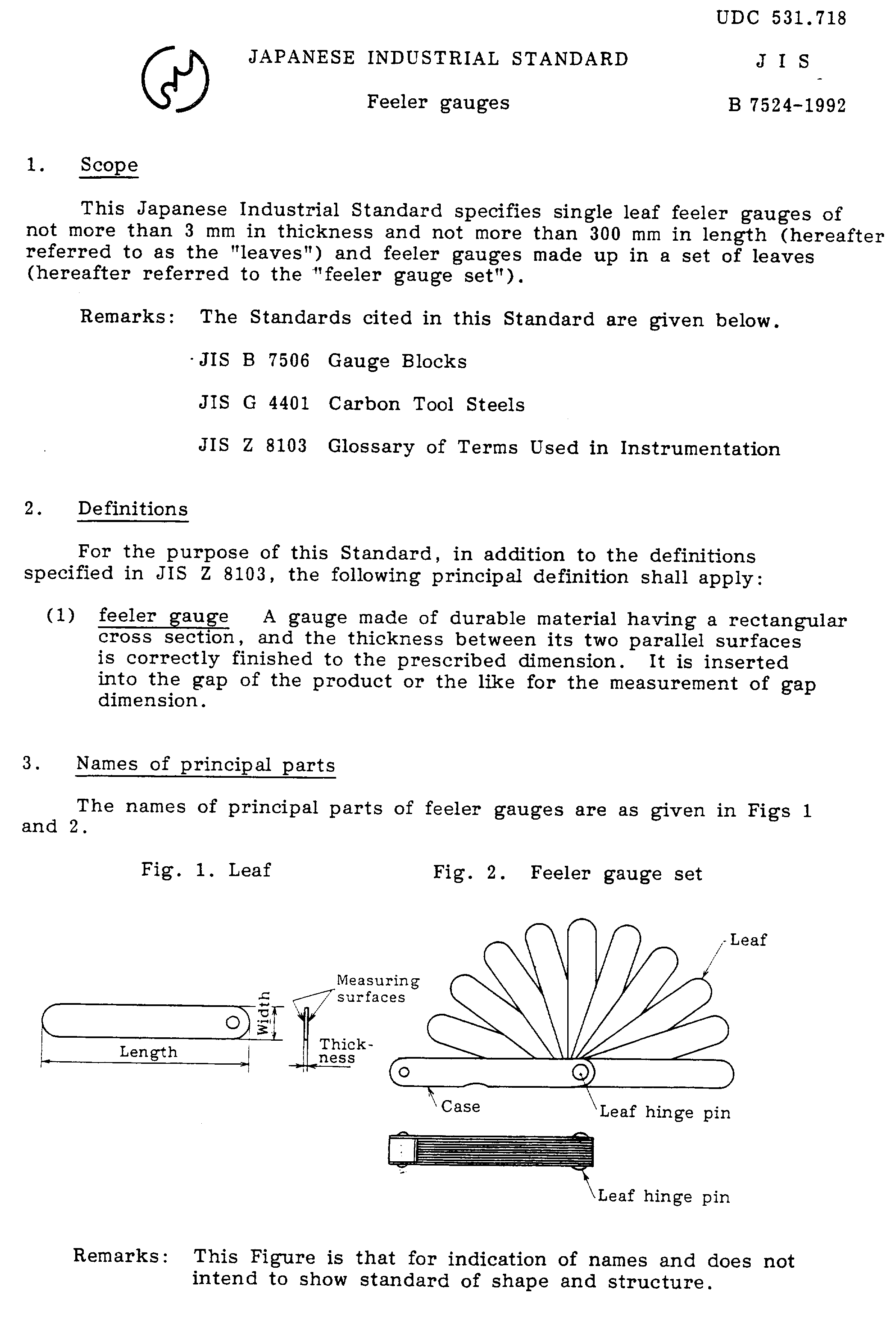

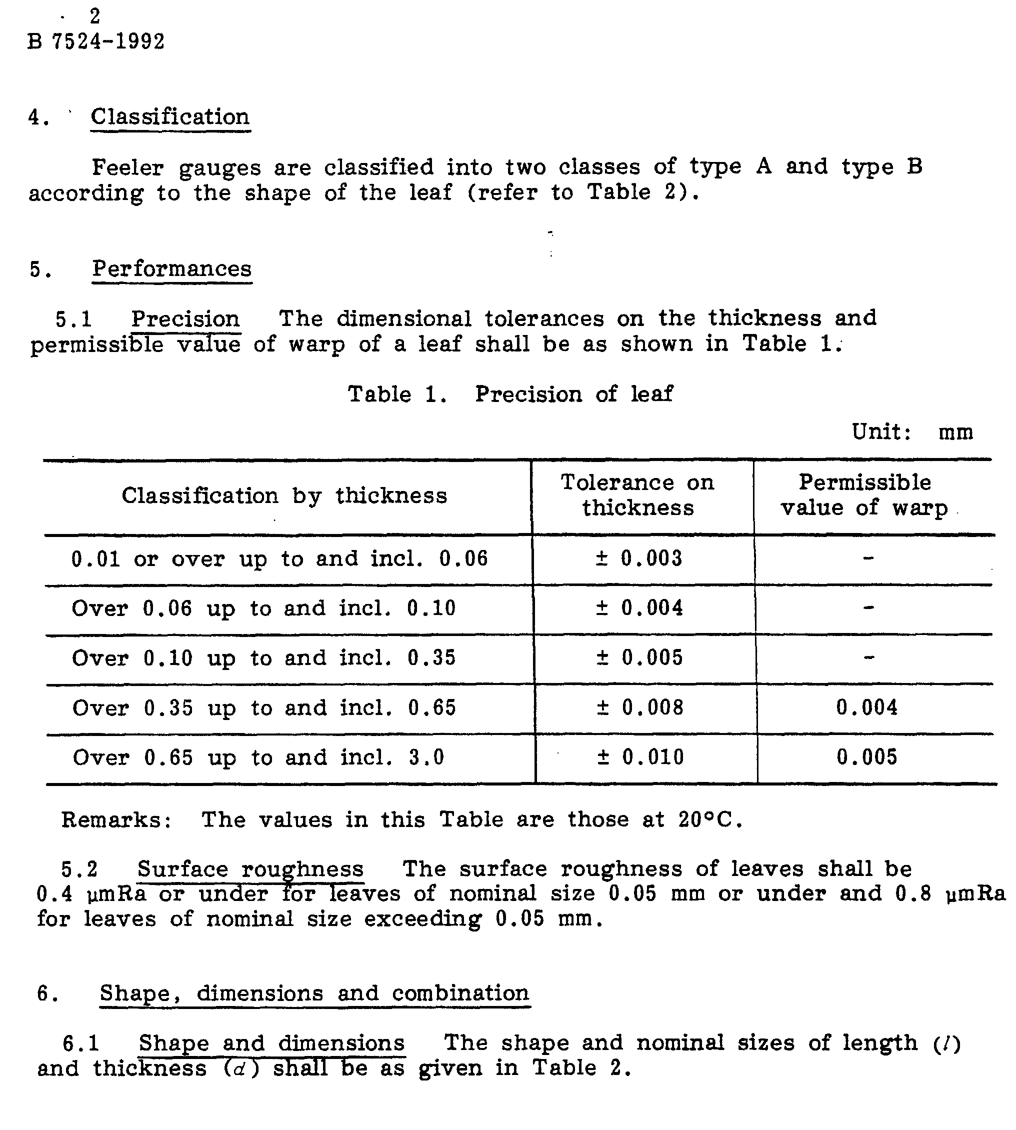

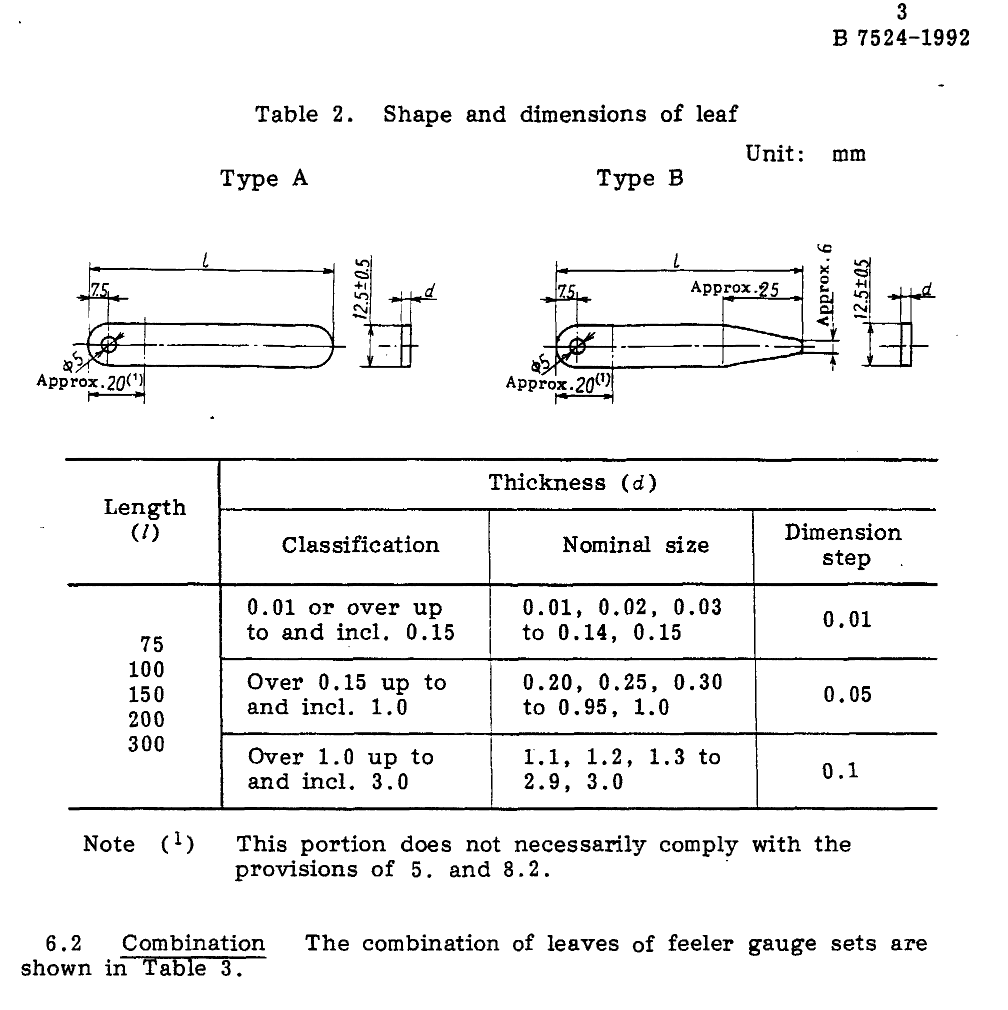

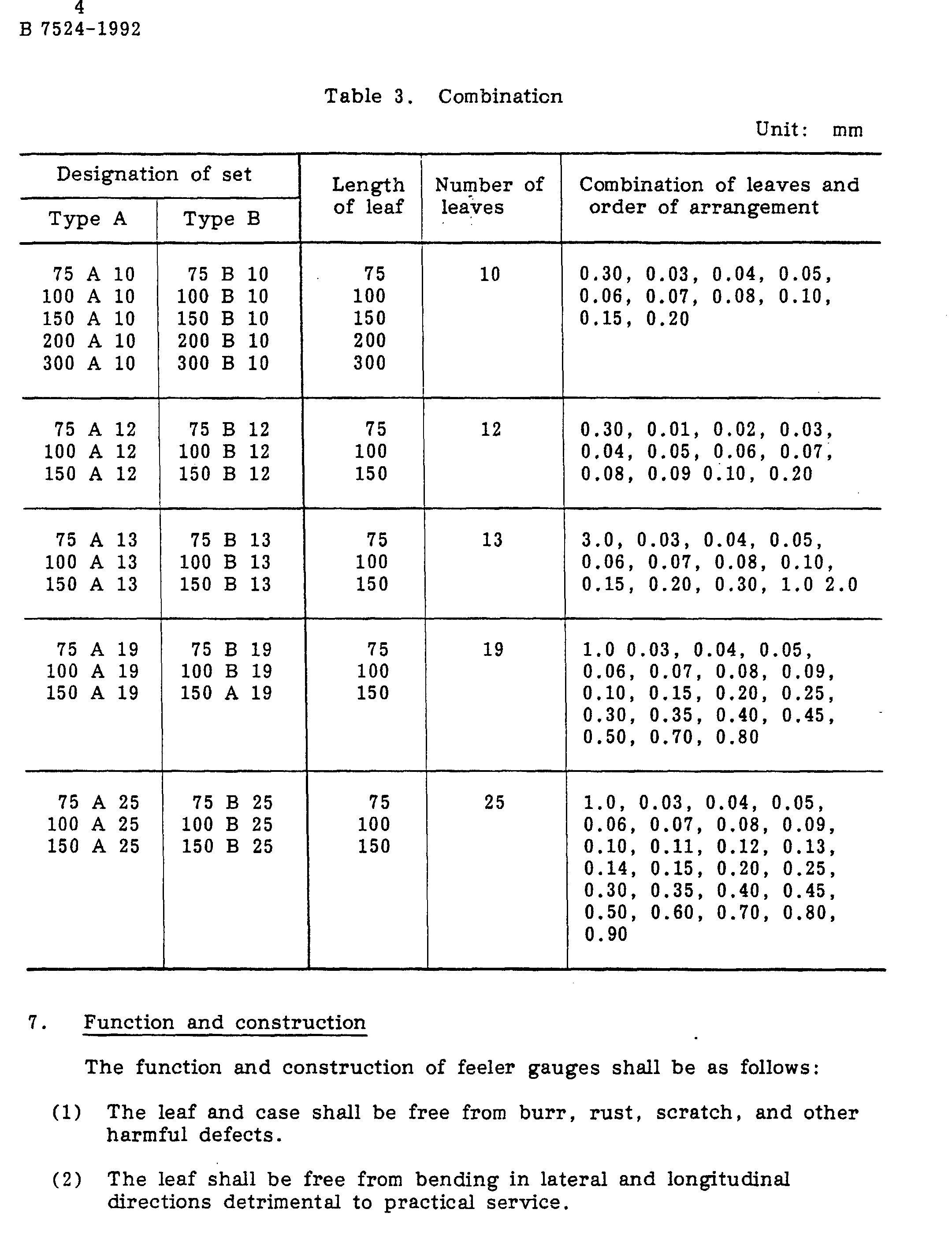

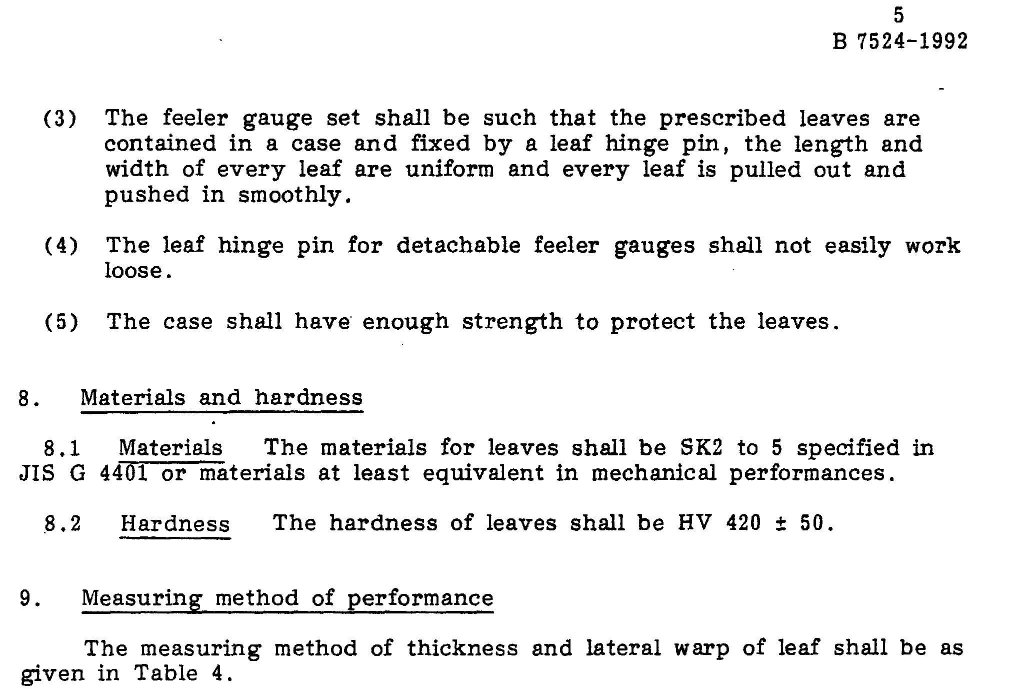

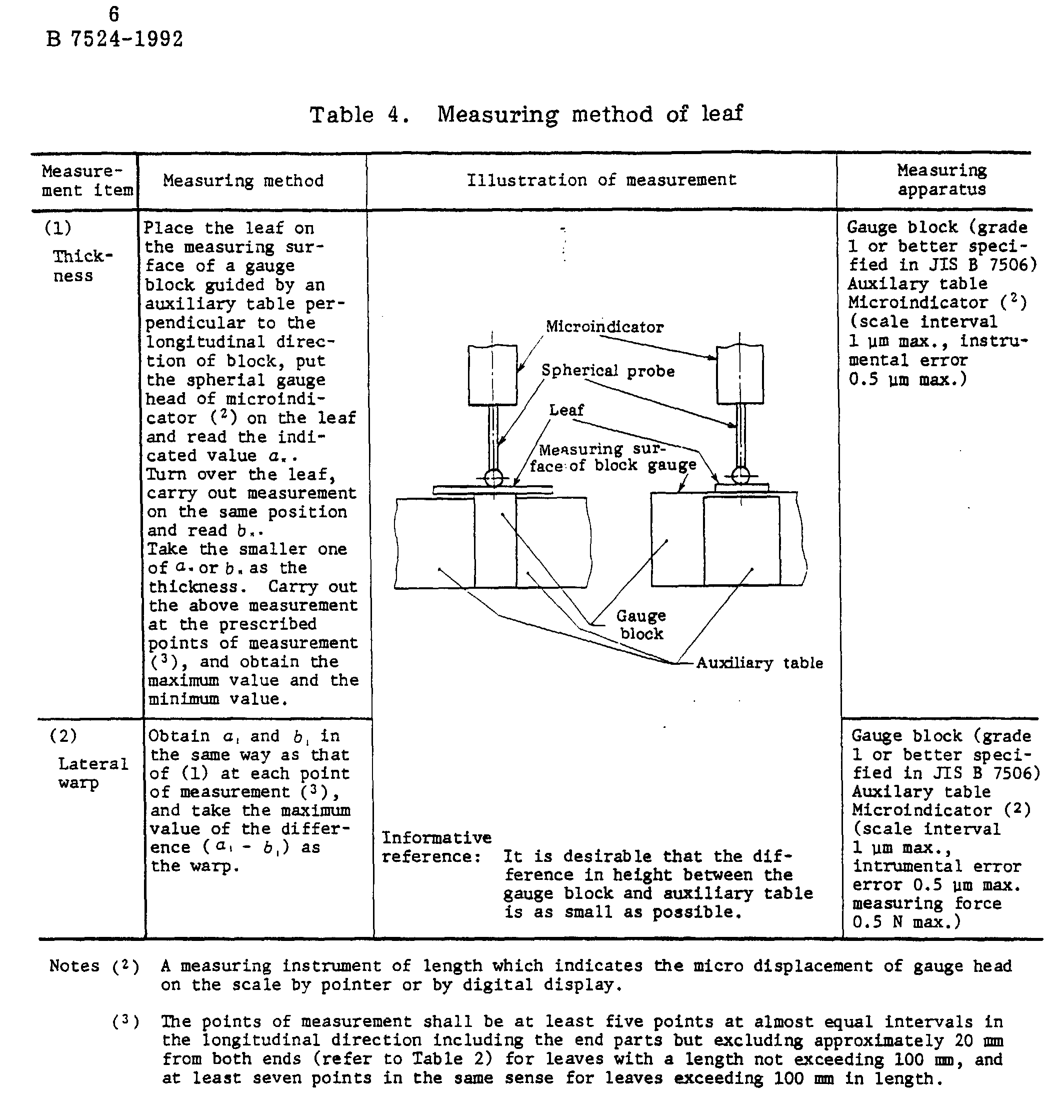

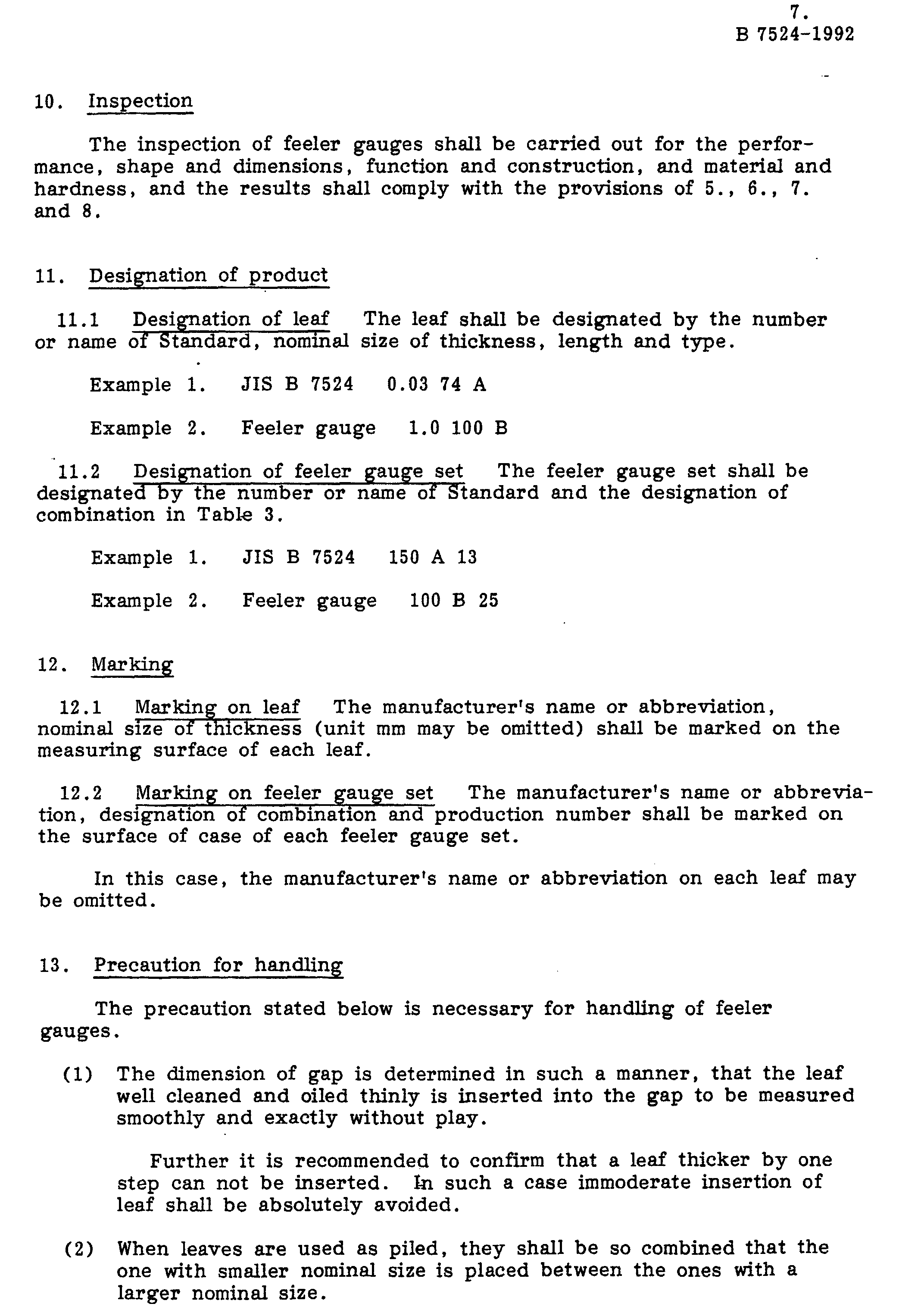

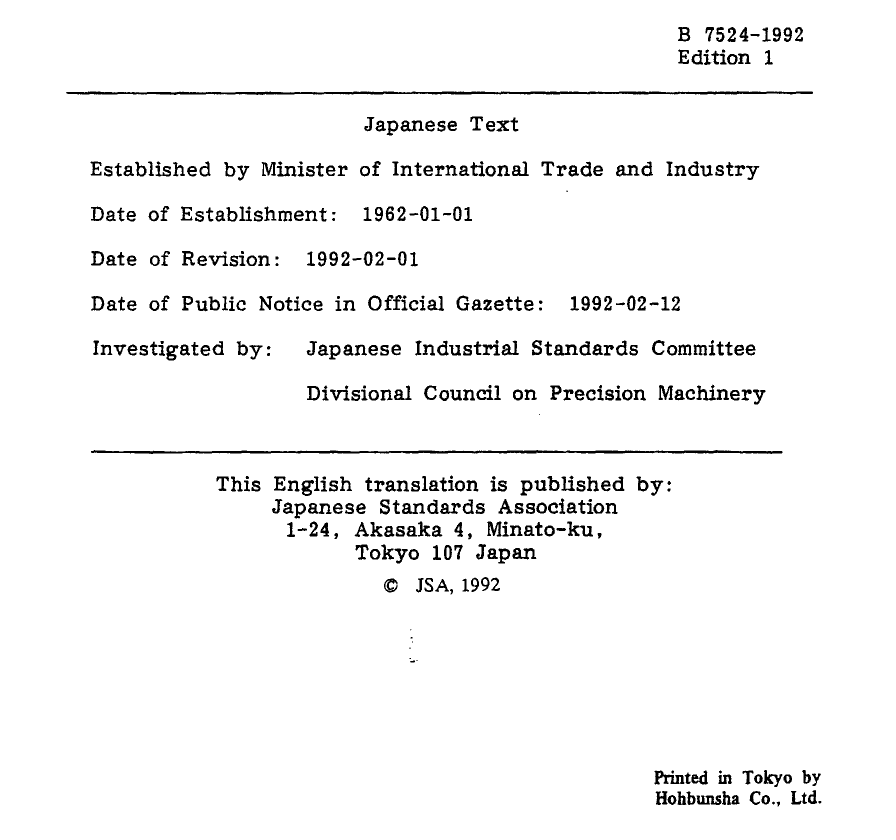

## Claims

1. A semiconductor unit comprising an IC package fitted on a printed wiring substrate and a heat dissipater provided on the IC package surface, characterized in that said unit further comprises a thermally conductive material having a thermal conductivity of at least 2.5 W/mK, measured with a hot-wire thermal conductivity meter, and being laid in a thickness of from 50 to 500 µm, measured according to JIS B 7524, between the IC package surface and the heat dissipater.

2. A semiconductor unit according to claim 1, wherein said thermally conductive material is a heat-reducing silicone grease composition.

3. A semiconductor unit according to claim 2, wherein the heat-reducing silicone grease composition is a composition having a viscosity of from 1,000 to 10,000 kgm⁻¹s⁻¹ (1,000 to 10,000 poise) when measured at 25°C with a spiral-pump viscometer.
